# EUROPEAN PATENT APPLICATION

(11) **EP 1 939 925 A1**
(43) Date of publication of application: **02.07.2008**
(21) Application number: 05786856.4
(22) Date of filing: 02.08.2005
(51) Int. Cl.: H01J 37/36, C23C 14/32

(54) **CATHODIC ARC EVAPORATION DEVICE AND METHOD OF IGNITING SAID ARC**

(71) Applicant: FUNDACION TEKNIKER, 20600 Eibar-Guipuzcoa (ES)
(72) Inventor: GOIKOETXEA LARRINAGA, Josu, E-48100 MUNGIA- VIZCAYA (ES)
(74) Representative: Carpintero Lopez, Francisco
(86) International application number: PCT/ES2005/000440
(87) International publication number: WO 2007/017528

(57) **Abstract**

The invention relates to a cathodic arc evaporation device comprising an evaporation chamber (2), at least one cathode (7) and at least one anode (13, 13A). The cathode (7) comprises a body of a material which is evaporated by the arc on an evaporation surface (71). According to the invention, an insert (100, 200) is disposed on the aforementioned evaporation surface (71), said insert comprising an electrically conductive part (101, 201) which projects out in relation to the evaporation surface (71), in order to establish a point for the easy formation of a spark. The inventive device also comprises a gas inlet (102, 202) which is aligned with the above-mentioned electrically-conductive part (101, 201) and which is used to inject a gas into the chamber (2) at said electrically conductive part, in order to facilitate the formation of a spark. The invention also relates to an arc ignition method.

## Description

### Field of the Invention

The invention is comprised in the field of cathodic arc evaporators.

### Background of the Invention

Cathodic arc evaporators used in machines for coating by PVD (Physical Vapour Deposition) and working in a reduced pressure environment (around 10⁻² mbar) are known. Systems of this type are described for example in U.S. patents US-A-3625848 and US-A-3783231. Their operation is based on evaporation of a cathode formed by the coating material. The evaporation is generated by means of an arc with electrical current established between at least one cathode and at least one anode arranged in an evaporation chamber. The evaporated material is deposited on an object housed in the evaporation chamber.

The traditional method of igniting the arc discharge between the cathode and the anode is by means of a mobile electrode connected to the anode through a small resistance (for example, of the order of about 10 Ohm), touching the cathode at the time in which the arc is to be ignited, whereby a short circuit is created. Once an electric current is established, the mobile electrode is removed from the cathode, which in turn produces the arc between the cathode and the anode. This mechanical method of igniting the arc discharge has the drawback of having a number of reliability problems, since the mobile electrode is frequently adhered to the surface of the cathode, whereby it is impossible to initiate the arc. It further requires the use of mobile elements (at least the electrode has to be mobile).

EP-A-0253435 describes a system for electronically igniting the electric arc between the cathode and the anode which in principle can operate without mobile elements. A gas is injected through an electrode in order to generate a higher pressure in a limited number of points between the parts in which the arc is to be ignited.

The gas is injected through a complementary anode or near a complementary anode. It thus seems that the greatest pressure increase occurs in correspondence with the anode. However it has been verified that this approach is possibly not the optimal approach, since in the process for electronically igniting the arc, the anode has a passive role and the relevant aspects of the ignition occur in correspondence with the cathode.

In addition, a problem for establishing the arc between the cathode and the anode(s) in the system described in EP-A-0253435 is related to the planar surface of the evaporation cathode against which the gas is injected. The arc has to be established on this surface, but its planar shape makes it very difficult, which demands a higher gas pressure and very high ignition voltages. Furthermore, the planar shape of the surface of the cathode makes it easy for the high voltage pulse used to generate the ignition of the arc to cause the spark to jump between unwanted points, such as for example between the electrical connection to the cathode and the body of the chamber. In addition the material which must be used in the cathode to obtain the desired coating can be such that it has a very low emission of electrons due to the thermionic effect, whereby it can be difficult to strike a spark thereon.

### Description of the Invention

A first aspect of the invention relates to a cathodic arc evaporation device for evaporating a material at subatmospheric pressure for coating parts, comprising an evaporation chamber configured to house at least one part to be coated (and which is normally configured to maintain a subatmospheric pressure within the chamber), and, in the chamber, at least one cathode and at least one anode, arranged such that an electric evaporation arc can be established in the chamber between said at least one cathode and said at least one anode, said cathode comprising a body made of a first material intended to be evaporated by said arc on an evaporation surface of the cathode.

This part of the system can be conventional and have, as is frequent in conventional evaporation systems, a planar evaporation surface on which it is relatively difficult for an arc to be ignited.

According to the invention, at least one insert is located in the evaporation surface of the body of the cathode, which insert has an electrically conductive part projecting out in relation to said evaporation surface, in order to establish a point for the easy formation of a spark. The device further comprises a gas inlet hole situated in correspondence with said electrically conductive part (specifically in the electrically conductive part itself or in an area near this electrically conductive part) for the injection of a gas into the chamber in correspondence with said electrically conductive part, in order to facilitate forming a spark at the point for the easy formation of a spark.

The electrically conductive part projecting from the evaporation surface allows easily generating the spark and arc in correspondence with this electrically conductive part (since the "projecting" shape gives rise to an increase in the local electric field). Given that the electrically conductive part projects from the actual evaporation surface, it is easy to move the arc towards said surface. The combination of injecting a small amount of gas with this element which "breaks" the planar and uniform character of the evaporation surface allows easily igniting the arc in the cathode without needing to use excessively high voltages, with the problems involved and which have been mentioned above.

The electrically conductive part projecting out in relation to the evaporation surface can end in a tip, such that a local increase of the electric field is generated in the area of said tip (since the electric field is increased at the tips of a conductive surface).

The gas outlet hole can be located at this tip, whereby ensuring that the gas pressure is maximum, or near the maximum, at the tip. To that end, the gas outlet hole can form the outlet of a conduit extending through said electrically conductive part.

The electrically conductive part can have a concave outer surface extending from the gas outlet hole (in which the outer surface of the electrically conductive part can be substantially perpendicular to the evaporation surface) to the base of the insert (in which the outer surface can be extended in parallel to the evaporation surface) in order to prevent abrupt changes in the surface which can make it difficult for the arc, once struck, to move from the insert to the evaporation surface.

The hole can alternatively be located not at the tip, but rather in an area near the tip. This can involve a certain reduction in the gas pressure at the tip if compared with the previously described modality, but this can be compensated for by making the tip sharper, using the fact that the projecting part establishing the tip does not have to house any gas conduit.

In this case the insert can comprise a base (which can be made or not made of the same electrically conductive material) in which the gas outlet hole is located, and an extension in the form of a needle or the like extending from said base such that it establishes the tip at a distance from said base (the distance must be small enough in order to ensure sufficient gas pressure in the area of the tip).

In both cases the hole can be small to ensure that a high local gas pressure can be obtained without having to inject an amount of gas substantially affecting the general pressure in the chamber. The hole can have a diameter of less than 3 mm in typical applications.

The electrically conductive part can be made of a heat-resistant material (to prevent the tip from deteriorating during the process). The material must also be tough in order to tolerate a sudden heating without breaking.

The electrically conductive part can be made of a material which the arc tends to avoid; this can be achieved for example by using a material with a low vapor pressure and/or with a high increase in resistivity with the temperature and/or with a low thermal conductivity for the electrically conductive part.

For example, the electrically conductive part can be made of a material comprising at least 30% by weight of a substance selected from the group comprising Zr, Nb, Mo, Hf, Ta, Re and W, or from a combination of said substances. For example, the electrically conductive part can comprise at least 30% by weight of Nb. Nb is a very suitable material for the electrically conductive part of the insert.

The electrically conductive part can be made of a material including elements emitting electrons by natural radiation (thorium for example) and/or including elements emitting electrons due to the thermionic effect (rare earth elements for example).

The insert can traverse the body of the cathode. For example, the insert can comprise, in addition to the electrically conductive part, an external part (which can also be electrically conductive in order to facilitate the connection to that of the electrically conductive part of the insert to an external electrical power supply) in which the electrically conductive part is screwed. This external part can be supported on an outer surface of the chamber, for example on the outer face of the body of the cathode. The external part can be supported on said outer surface of the chamber with the interposition of an o-ring gasket in order to prevent fluids from entering the chamber through the perforation or the like in the body of the cathode in which the insert can be placed.

The device can additionally comprise an electric ignition system comprising means for generating high frequency electrical pulses, for example between 0.5 and 10 Mhz between the anode and the cathode to ignite the arc. A conventional electric ignition system can be used for this purpose.

The device can additionally comprise a gas injection system for injecting gas through the hole. This gas injection system can comprise a quick opening valve.

The device can additionally comprise a magnetic arc guide system which can comprise one or more coils to generate a variable or nonvariable magnetic field. With a variable field, the movement of the arc can be controlled and varied by means of a variation in the magnetic field.

The magnetic guide system can be configured to move the arc according to a path, the insert being located away from said path. The time the arc is situated in correspondence with the insert is thus reduced.

The device can comprise at least two anodes and can be configured such that at least one first anode acts as an anode in a phase of igniting the arc, and such that at least one second anode (which can be the actual walls of the chamber) acts as an anode during the operation of the device once the arc is ignited.

It is also possible that the device comprises a plurality of cathodes and only one anode shared by the cathodes.

Another aspect of the invention relates to a method of igniting an arc in a device according to that described above. The method comprises the steps of injecting an amount of gas through the hole and applying high frequency electrical pulses, for example between 0.5 and 10 Mhz between the anode and the cathode to ignite the arc. The injected gas can be an easily ionizable gas, for example, argon, krypton or xenon.

### Description of the Drawings

To complement the description and for the purpose of aiding to better understand the features of the invention according to several preferred practical embodiments thereof, a set of drawings is attached as an integral part of said specification, in which the following has been shown with an illustrative and nonlimiting character:
Figure 1 shows a schematic view of the device according to a first embodiment of the invention.
Figure 2 shows a view similar to that of Figure 1 but including a magnetic arc guide system.
Figure 3 shows a schematic view of a second embodiment of the invention.
Figure 4 shows a detail of the insert according to a possible modality of the first embodiment of the invention.
Figure 5 shows a schematic view of a device with several cathodes and an anode common to the cathodes.
Figures 6 and 7 show two configuration variants of the anode part of the chamber.

### Preferred Embodiment of the Invention

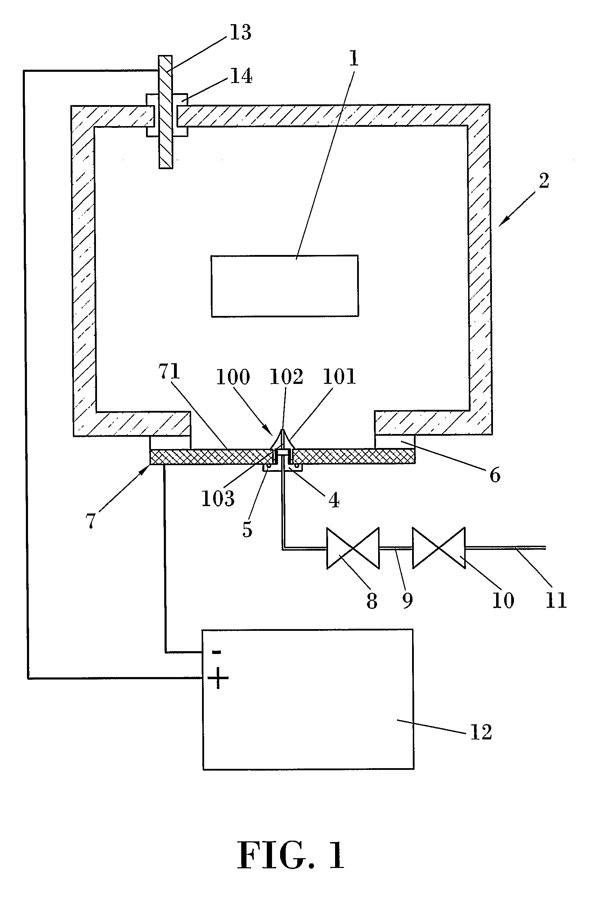

Figure 1 shows a schematic image of a device according to a first embodiment of the invention. In order to carry out a coating, the part 1 to be coated is introduced inside the chamber 2 in which a vacuum of the order of 5 x 10⁻⁵ mbar is carried out and is heated. Once the required temperature and degree of vacuum are reached, the chamber is filled with suitable process gases (for example argon, nitrogen, acetylene...) to a pressure of approximately 7 x 10⁻³ mbar. The pressure is maintained constant by the equilibrium established between the gas introduced through regulated valves and the gas which is aspirated through an assembly of high vacuum pumps installed in the chamber (this part of the system is conventional and has not been depicted in the figures for the purpose of facilitating the understanding of the novel part of the system). Once this is completed, a direct-current electric arc is ignited which is established between a part acting as a cathode 7 and another part acting as an anode 13. The part acting as a cathode 7 evaporates material due to the effect of the actuation of the arc and this evaporated material travels through the partial vacuum of the chamber to be deposited on the part 1 to be coated. The evaporation occurs on an evaporation surface 71 of the body of the cathode. The cathode 7 is electrically insulated from the chamber through an insulating part 6 interposed between the cathode 7 and the walls of the chamber. In Figure 1, the anode 13 is also insulated from the chamber by means of an interposed insulating part 14, but in a number of cases the body of the chamber acts as an anode. As is conventional, both the cathode 7 and the anode 13 have cooling systems (not shown). The cathode and the anode are connected to respective terminals of a direct-current power supply 12 such as those used in welding metal elements and which is provided with an electronic ignition system based on brief high frequency pulses (these types of ignition systems are conventional and are described in U.S. patents US-A-3008036, US-A-3154719 and US-A-3876855 for example, therefore this ignition system does not have to be described with more detail in this patent.

Despite the electronic ignition system which this power supply has, the application of such pulses to a conventional arc evaporator is not able to cause the ignition of the arc, since the part acting as a cathode 7 and evaporating the material normally has a planar and very clean surface because of the action of the vacuum evaporation, and these two circumstances make it difficult for the spark to be produced, therefore the electronic ignition system usually reaches the voltage limit that it has prefixed for safety reasons without having been able to produce spark between the cathode and the anode. Alternatively, it can also occur that the spark between the cathode and the anode is split into two sparks in series, one spark between the cathode and the ground and another spark between the ground and the anode, and that both sparks are produced between the surfaces of those parts which are located outside the vacuum chamber.

In order to prevent all these problems the insert 100 is provided, configured to optimize the probability of the spark jumping from the cathode, which is the most active and important element in this task, since the function of the anode is virtually passive. The insert 100 is placed in the evaporation target (formed by the body of the cathode 7) and ends in a tip projecting out in relation to the evaporation surface 71. The insert has an electrically conductive part 101 which is traversed by a conduit 103 opening out into a hole 102 at the tip of the insert. A blast of gas can be injected through the conduit 103 at the time in which the electronic ignition of the power supply 12 is acting; this blast of gas comes out of the hole 102 whereby a pressure increase occurs right at the tip of the insert 100.

The electric field in an equipotential surface, such as that of a metal, is inversely proportional to its radius of curvature, therefore if the radius of curvature of the tip of the insert 100 is very small, the electric field in its surrounding areas and therefore the probability of ionizing the surrounding gas greatly increases, whereby facilitating the formation of the spark. For this purpose it is also advisable that the gas outlet is small (for example between 1 and 2 mm) so that the local pressure at the outlet point is high. As is common in these types of systems, the gas injected for striking can be argon, which is inert and easily ionizable.

The insert 100 is manufactured in a heat-resistant material such that the temporary action of the arc on the tip and the gas outlet hole at the time of striking will not cause a rounding of the tip, reducing its long term efficiency. The material must likewise be tough enough to tolerate the sudden localized heating caused by the arc without breaking.

There is the risk that, even in the event that there is a magnetic field pushing the arc away from the insert, the arc tends to be struck in the insert and does not migrate to the surrounding area, which is where it must act in order to evaporate the material with which the part 1 is to be coated. In order to reduce this risk, it is advisable that the insert be manufactured in a material that the electric arc tends to avoid, as a result of its very low vapor pressure or of its quick increase of electric resistivity with temperature for example, such that once the arc is established it spontaneously tends to migrate to the surrounding surface. To that end, in this embodiment of the invention, the electrically conductive part 101 of the insert is manufactured in a material with a high content of niobium (Nb), which is a material having all these suitable features for the insert.

In order to facilitate the production of the spark, the electrically conductive part 101 can include in its composition elements that emit electrons naturally as a result of their natural radioactivity (thorium) and/or elements with a marked emission of electrons due to the thermionic effect, as a result of having a very low value for the work function (such as rare earth elements, including cerium and lanthanum).

Although it would have been possible to simply screw the electrically conductive part 101 of the insert into the evaporation material forming the body of the cathode 7, it must be taken into account that this body can be made of a material which can have machining difficulties. To that end the electrically conductive part 101 can be screwed into another part 4, such that the material to be evaporated is compressed between both parts. The part 4 is supported on the outer surface of the body of the cathode and an o-ring gasket 5 has been interposed in order to ensure the good sealing of this point, such that the fluid in contact with the outer part of the evaporation material 7, which can be cooling water or air, does not penetrate the vacuum chamber through the hole in which the insert 100 is assembled.

The introduction of gas simultaneously with the application of the high frequency pulses is carried out by means of a quick opening valve 8 located near the insert 100 and communicating with the hole 102 of the insert. The amount of gas necessary for facilitating the production of the spark decreases with the distance from the valve 8 to the hole. Said amount of introduced gas is that which is trapped in the section 9 located between the valve regulating the inlet 8 and another valve 10 which allows loading this redoubt with gas through its connection 11 to a gas supply source. Whenever the gas enclosed in the section 9 is discharged through the valve 8, this space is loaded again with gas through the valve 10 (once the valve 8 has been closed again). A person having ordinary skill in the art can easily choose the suitable dimensions of the gas pipes and of the distances between valves, so as to obtain an injection of a suitable amount of gas according to the specific features of the device. For example, in several applications it can be sufficient to supply 2 cubic centimeters of standard pressurized gas to cause the ignition, which in most production systems involves a very small alteration of the process, an alteration which can be perfectly taken on.

It is advisable to not inject more gas than is strictly necessary for causing the striking of the arc, since while the gas leaves through the tip of the insert, the arc tends to remain therein, deteriorating it and evaporating the material of the insert instead of the material of the surrounding target, which can also influence the quality of the coating obtained.

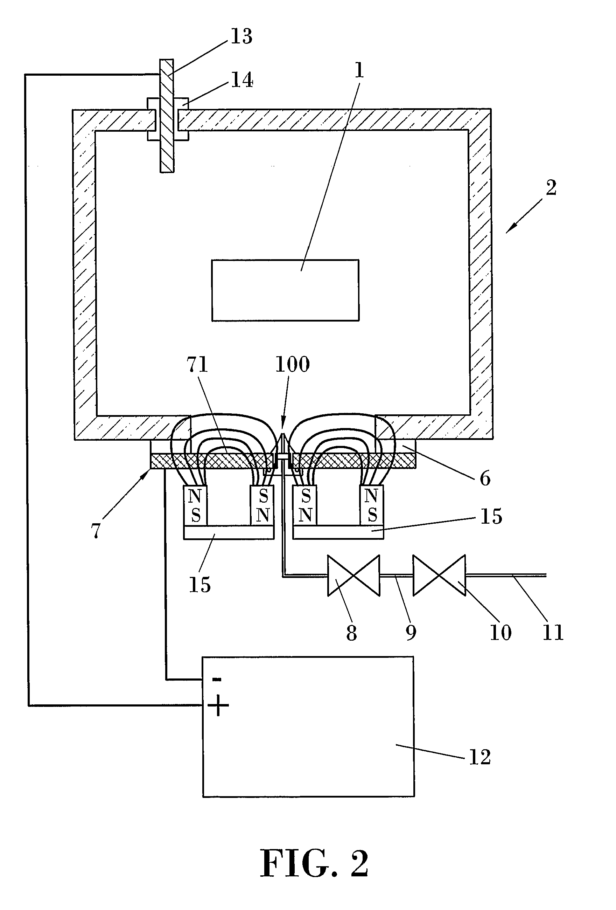

Figure 2 shows a configuration similar to that of Figure 1 (the identical elements have the same reference numbers) but with the incorporation of a magnetic arc guide system 15. As described in U.S. patent US-A-4724058, the existence of a magnetic field having on the surface of the evaporation material a path formed by points in which the magnetic field is parallel to the surface of the cathode, forces the hot point of the electric arc to follow that path. By placing the insert 100 for striking the arc in a position outside that path, the magnetic field contributes to decreasing the time that the arc needs to move from the insert 100 in which the striking occurs to the evaporation surface 71 of the contiguous evaporation target. The magnetic assembly responsible for guiding the arc can additionally include among its components one or several coils which allow modifying the location of the path followed by the arc, as stated in international patent application WO-A-02/077318.

The action of the magnetic guide can therefore be synchronized with that of the striking such that when it is to be struck the magnetic guide is configured to guide the arc towards the path furthest from the insert 100, such that the thrust which the magnetic field exerts on the arc in order to move it away from the insert is maximized.

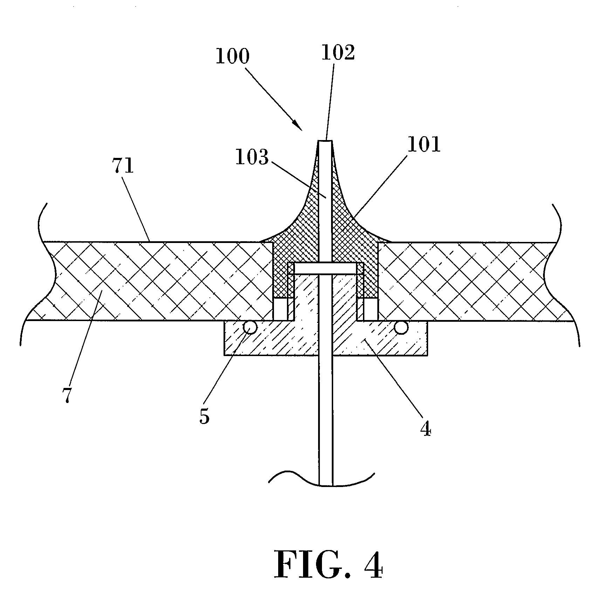

Figure 4 shows a detail of a possible configuration of the insert 100: to contribute to reducing the time that the arc takes to migrate from the striking area to the evaporation area, the shape of the electrically conductive part projecting out in relation to the evaporation surface 71 can be as depicted in Figure 4, i.e. substantially concave. The electrically conductive part 101 thus has an outer surface making a gradual transition from the tip, in which the surface of the insert 100 is virtually perpendicular to the evaporation surface 71, to the base on which it gradually meets the evaporation surface. Discontinuities in the surface which could be used to anchor the hot point of the arc and prevent its migration to the evaporation surface 71 are thus prevented.

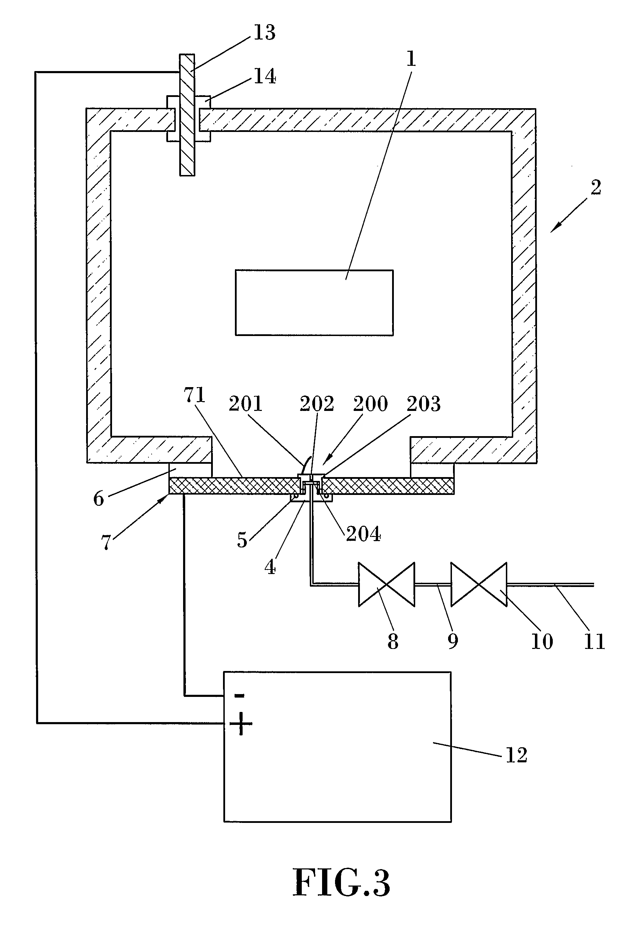

Figure 3 shows a second embodiment of the invention. The basic structure of the device coincides with that of Figure 1 and identical parts have the same reference numbers. However in this case the cathode 7 has been provided with another type of insert 200, specifically with an insert comprising an electrically conductive part comprising a base 203 having a gas conduit 204 opening out into a hole 202 provided in said base. Next to the hole 202 there is an extension 201 in the form of a needle forming a very sharp tip in an area located at a small distance from the hole 202. The reduction in the effectiveness for the striking caused by the decrease of the gas pressure in the surrounding areas of the tip is more than compensated for by decreasing the radius of curvature at the tip which can be achieved by using a filament fine enough for said extension 201, and this in turn greatly increases the electric field in its surrounding areas and consequently the probabilities of ionizing the surrounding gas and of forming the spark.

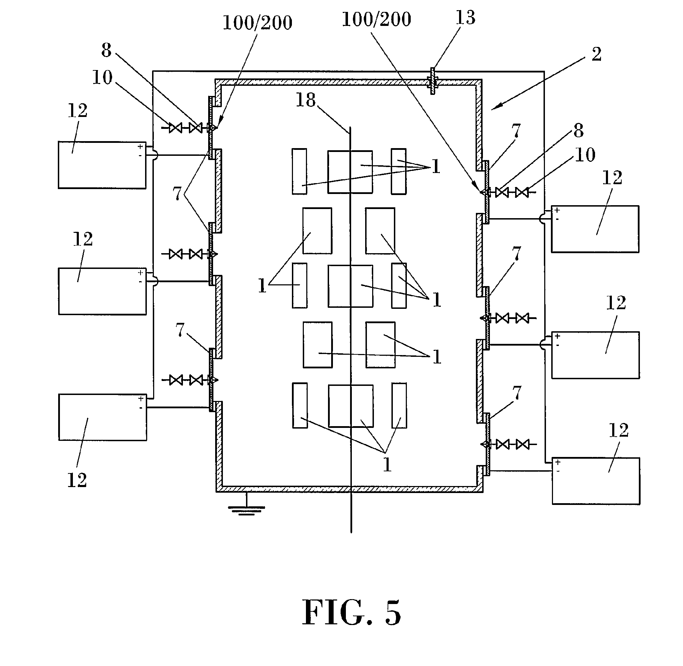

Unlike that set forth in EP-A-0253435, the systems described above do not require an auxiliary anode located in their surrounding areas, but rather the anode can be located at any point of the chamber and one and the same anode can even be shared by several evaporators, as depicted in Figure 5, showing a set of parts 1 rotating about a vertical axis 18 immersed in a more or less cylindrical shaped chamber, on the side walls of which there are many small evaporators installed formed by the respective cathodes 7, as is common in currently existing systems. Each of these cathodes is provided with its corresponding insert 100 or 200 and all of them are connected to a common remote anode 13. Unlike that set forth in EP-A-0253435, with the system of the present invention it is not necessary for the gas introduced to facilitate the electronic ignition to cause a pressure increase in the surrounding areas of the anode (which would be the same as saying in the entire vacuum chamber, given the distanced position of the anode), but rather it is enough that this pressure increase occurs in the surrounding areas of the tip of the insert 100 or 200 placed in the cathode. The distancing of the anode in relation to the cathode, which is possible with the present invention, can be advantageous since it makes it difficult for the jump of the spark between both elements to occur at the outer part of the chamber. The invention allows this without reducing the capacity for the spark to jump through the inside of the vacuum chamber, whereby increasing the reliability of the device.

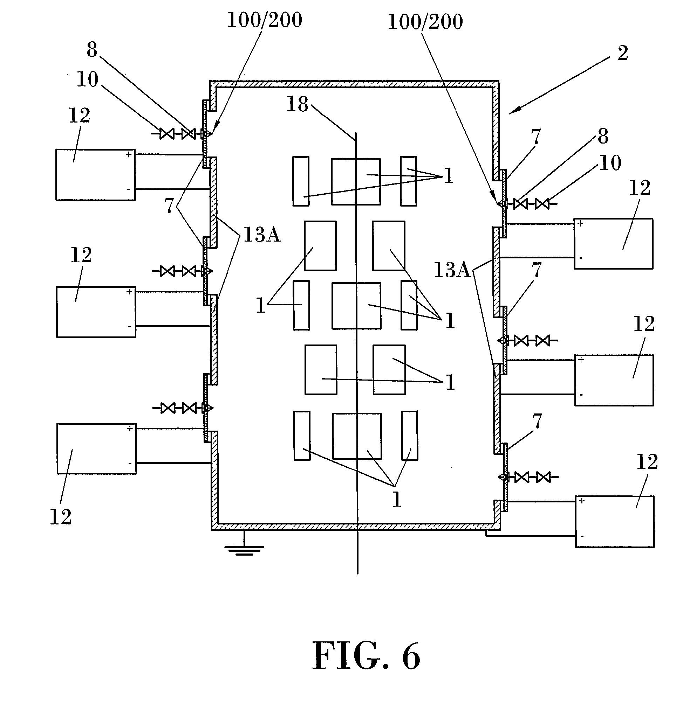

Figure 6 shows another configuration in which the function of an anode 13A for the multiple evaporators has be assigned to the walls of the vacuum chamber.

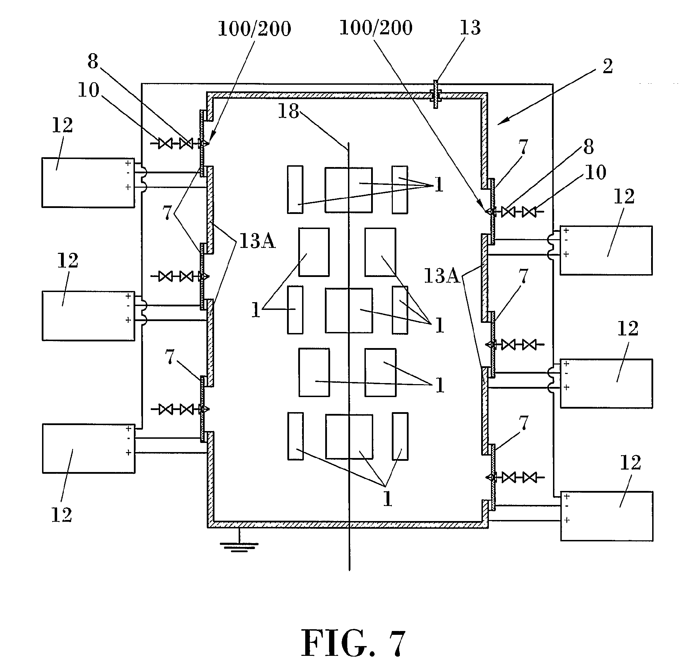

Figure 7 shows yet another configuration in which the power sources have two connections for anodes: one connection functioning as such in the arc discharge for most of the time and which is connected to the walls 13A of the chamber; and another connection which is connected to an individual anode 13 which is only used for striking the arc since it is more advantageous than the walls of the chamber for this function, as it has less electric capacity, and is more suitable for high frequency transmission, and because in this way the striking anode and cathode can be physically moved apart.

In this text, the word "comprise" and its variants (such as "comprising", etc.) must not be interpreted in an exclusive manner, i.e. they do not exclude the possibility that that described includes other elements, steps etc.

In addition the invention is not limited to the specific embodiments which have been described but rather it also covers, for example, the variants which can be carried out by the person having ordinary skill in the art (for example, as regards choosing materials, dimensions, components, configuration, etc.), within what is inferred from the claims.

## Claims

1. A cathodic arc evaporation device for evaporating material at subatmospheric pressure for coating parts (1), comprising an evaporation chamber (2) configured to house at least one part to be coated, and in the chamber (2) at least one cathode (7) and at least one anode (13, 13A), arranged such that an electric evaporation arc can be established in the chamber between said at least one cathode and said at least one anode, said cathode (7) comprising a body made of a first material intended to be evaporated by said arc on an evaporation surface (71) of the cathode; **characterized in that** at least one insert (100, 200) is located in said evaporation surface (71) of said body of the cathode (7), which insert has an electrically conductive part (101, 201) projecting out in relation to said evaporation surface (71), in order to establish a point for the easy formation of a spark, and **in that** the device further comprises a gas inlet hole (102, 202) situated in correspondence with said electrically conductive part (101, 201) for the injection of a gas into the chamber (2) in correspondence with said electrically conductive part in order to facilitate forming a spark at the point for the easy formation of a spark.

2. A device according to claim 1, **characterized in that** the electrically conductive part (101, 201) projecting out in relation to the evaporation surface ends in a tip.

3. A device according to claim 2, **characterized in that** the hole (102) is located at said tip.

4. A device according to claim 3, **characterized in that** the hole (102) forms the outlet of a conduit (103) extending through said electrically conductive part (101).

5. A device according to claim 2, **characterized in that** the hole (202) is located in an area close to the tip.

6. A device according to claim 5, **characterized in that** the insert comprises a base (203) in which the hole (202) is located, and an extension (201) in the form of a needle extending from said base such that it establishes the tip at a distance from said base.

7. A device according to any of the previous claims, **characterized in that** the hole has a diameter of less than 3 mm.

8. A device according to any of the previous claims, **characterized in that** the electrically conductive part (101, 201) is made of a heat-resistant material.

9. A device according to any of the previous claims, **characterized in that** the electrically conductive part (101, 201) is made of a material with a low vapor pressure and/or with a quick increase in electric resistivity with the temperature and/or with a low thermal conductivity.

10. A device according to any of the previous claims, **characterized in that** the electrically conductive part (101, 201) is made of a material comprising at least 30% by weight of a substance selected from the group comprising Zr, Nb, Mo, Hf, Ta, Re and W, or from a combination of said substances.

11. A device according to claim 10, **characterized in that** the electrically conductive part (101, 201) comprises at least 30% by weight of Nb.

12. A device according to any of the previous claims, **characterized in that** the electrically conductive part (101, 201) is made of a material including elements emitting electrons by natural radiation.

13. A device according to any of the previous claims, **characterized in that** the electrically conductive part (101, 201) is made of a material including elements emitting electrons due to the thermionic effect.

14. A device according to any of the previous claims, **characterized in that** the insert (100, 200) traverses the body of the cathode (7).

15. A device according to claim 14, **characterized in that** the insert (100, 200) comprises, in addition to the electrically conductive part (101, 201), an external part (4) in which the electrically conductive part is screwed, said external part (4) being supported on an outer surface of the chamber.

16. A device according to claim 15, **characterized in that** said external part (4) is supported on said outer surface of the chamber with the interposition of an o-ring gasket (5).

17. A device according to any of the previous claims, **characterized in that** it additionally comprises an electric ignition system comprising means for generating high frequency electrical pulses between the anode (13, 13A) and the cathode (7) to ignite the arc.

18. A device according to any of the previous claims, **characterized in that** it comprises a gas injection system (8, 9, 10, 11) for injecting gas through the hole (102, 202), said gas injection system comprising a quick opening valve (8).

19. A device according to any of the previous claims, **characterized in that** it additionally comprises a magnetic arc guide system (15).

20. A device according to claim 19, **characterized in that** said magnetic guide system (15) is configured to move the arc according to a path, the insert being located away from said path.

21. A device according to any of the previous claims, **characterized in that** it comprises at least two anodes (13, 13A), the device being configured such that at least one first anode (13) acts as an anode in a phase of igniting the arc, and such that at least one second anode (13A) acts as an anode during the operation of the device once the arc is ignited.

22. A device according to any of claims 1-20, **characterized in that** it comprises a plurality of cathodes (7) and only one anode (13).

23. A method of igniting an arc in a device according to any of the previous claims, **characterized in that** it comprises the steps of injecting an amount of gas through the hole (102, 202) and applying high frequency electrical pulses between the anode and the cathode to ignite the arc.

24. A method according to claim 23, **characterized in that** the high frequency is a frequency of between 0.5 and 10 Mhz.

25. A method according to any of claims 23 and 24, **characterized in that** the injected gas is an easily ionizable gas.

26. A method according to claim 25, **characterized in that** said gas is argon, krypton or xenon.
